# FASCICULE DE BREVET EUROPEEN

(11) **EP 2 932 588 B1**
(45) Date de publication et mention de la délivrance du brevet: **26.09.2018**
(21) Numéro de dépôt: 13782792.9
(22) Date de dépôt: 03.10.2013
(51) Int. Cl.: H02M 1/36, G01R 19/165, H03K 5/08

(54) **CIRCUIT DE COMPARAISON D'UNE TENSION A UN SEUIL ET CONVERSION D'ENERGIE ELECTRIQUE**
SCHALTUNG ZUM VERGLEICHEN EINER SPANNUNG MIT EINEM SCHWELLENWERT UND UMWANDLUNG VON ELEKTRISCHER ENERGIE
CIRCUIT FOR COMPARISON OF A VOLTAGE WITH A THRESHOLD AND CONVERSION OF ELECTRICAL ENERGY

(30) Priorité: 11.12.2012 WO PCT/FR2012/052880
(43) Date de publication de la demande: 21.10.2015
(73) Titulaire: Commissariat à l'Energie Atomique et aux Energies Alternatives, 75015 Paris (FR)
(72) Inventeur: BOISSEAU, Sébastien, 38130 Échirolles (FR); DESPESSE, Ghislain, 38340 Voreppe (FR)
(74) Mandataire: Cabinet Beaumont
(86) Numéro de dépôt international: PCT/FR2013/052356
(87) Numéro de publication internationale: WO 2014/091096

(56) Documents cités:
- KR-A- 20080 089 752
- US-A1- 2007 035 334
- US-A1- 2011 109 347
- YUAN RAO ET AL: "An input-powered active AC/DC converter with zero standby power for energy harvesting applications", ENERGY CONVERSION CONGRESS AND EXPOSITION (ECCE), 2010 IEEE, IEEE, PISCATAWAY, NJ, USA, 12 septembre 2010 (2010-09-12), pages 4441-4446, XP031787642, ISBN: 978-1-4244-5286-6
- GASNIER P ET AL: "Power conversion and integrated circuit architecture for high voltage piezoelectric energy harvesting", NEW CIRCUITS AND SYSTEMS CONFERENCE (NEWCAS), 2012 IEEE 10TH INTERNATIONAL, IEEE, 17 juin 2012 (2012-06-17), pages 377-380, XP032248100, DOI: 10.1109/NEWCAS.2012.6329035 ISBN: 978-1-4673-0857-1 cité dans la demande
- DAN NIU ET AL: "A sub-0.3V CMOS rectifier for energy harvesting applications", CIRCUITS AND SYSTEMS (MWSCAS), 2011 IEEE 54TH INTERNATIONAL MIDWEST SYMPOSIUM ON, IEEE, 7 août 2011 (2011-08-07), pages 1-4, XP031941291, DOI: 10.1109/MWSCAS.2011.6026347 ISBN: 978-1-61284-856-3

## Description

### Domaine

La présente demande concerne la conversion d'énergie électrique de façon générale, et vise plus particulièrement la conversion d'énergie électrique dans des générateurs ou alimentations à récupération d'énergie ambiante. La présente demande vise aussi un circuit de comparaison d'une tension à un seuil.

### Exposé de l'art antérieur

Pour alimenter des systèmes électroniques à faible consommation d'énergie, on a proposé d'utiliser des générateurs adaptés à convertir de l'énergie disponible dans l'environnement du système, par exemple de l'énergie mécanique, en énergie électrique. On connaît notamment des générateurs dans lesquels de l'énergie mécanique ambiante est convertie en énergie électrique par un élément piézoélectrique. Pour transformer l'énergie électrique fournie par l'élément piézoélectrique en énergie électrique exploitable par un système électronique, ces générateurs comprennent un dispositif de conversion d'énergie électrique placé en aval de l'élément piézoélectrique. Le dispositif de conversion d'énergie électrique peut comprendre un circuit de comparaison d'une tension à un seuil.

Des exemples de dispositifs de conversion d'énergie électrique sont notamment décrits dans la demande de brevet français publiée sous le numéro 2873242, précédemment déposée par la demanderesse, dans l'article "Power Conversion and Integrated Circuit Architecture for High Voltage Piezoelectric Energy Harvesting" de Pierre Gasnier et al., et dans la demande de brevet américain US 2001/109347 A1.

### Résumé

Un mode de réalisation prévoit un circuit de comparaison d'une tension à un seuil, comportant : un premier inverseur dont des premier et second noeuds d'alimentation sont couplés respectivement à des premier et second noeuds d'application de ladite tension ; et un premier interrupteur normalement fermé reliant une entrée du premier inverseur au premier noeud d'application de la tension, une grille de commande du premier interrupteur étant reliée au deuxième noeud d'application de la tension.

Le premier noeud d'alimentation du premier inverseur est relié au premier noeud d'application de la tension par l'intermédiaire d'un limiteur de tension.

Selon un mode de réalisation, le limiteur de tension comprend un deuxième interrupteur normalement fermé entre le premier noeud d'application de la tension et le premier noeud d'alimentation du premier inverseur.

Selon un mode de réalisation, le limiteur de tension comprend en outre au moins un troisième interrupteur normalement fermé cascadé avec le deuxième interrupteur.

Selon un mode de réalisation, le limiteur de tension comprend une diode dont l'anode est côté premier noeud d'application de la tension et dont la cathode est côté premier noeud d'alimentation du premier inverseur.

Selon un mode de réalisation, le circuit de comparaison comporte un deuxième inverseur en série avec le premier inverseur.

Selon un mode de réalisation, un noeud de sortie du circuit de comparaison est relié à une sortie du deuxième inverseur.

Selon un mode de réalisation, le premier interrupteur est un transistor MOS à déplétion.

Selon un mode de réalisation, l'entrée du premier inverseur est reliée à une sortie du circuit de comparaison par l'intermédiaire d'une première résistance.

Selon un mode de réalisation, l'entrée du premier inverseur est reliée au deuxième noeud d'application de la tension par l'intermédiaire d'une deuxième résistance.

Selon un mode de réalisation, l'entrée du premier inverseur est reliée au premier interrupteur par l'intermédiaire d'une troisième résistance.

Un autre mode de réalisation prévoit un circuit de conversion d'énergie comportant : un premier élément comprenant un convertisseur d'énergie électrique ; et un circuit de comparaison de tension du type susmentionné.

Selon un mode de réalisation, le circuit de conversion d'énergie comporte en outre un deuxième élément de stockage d'énergie électrique, susceptible d'être alimenté par le premier élément.

Selon un mode de réalisation, le circuit de conversion d'énergie comporte en outre un interrupteur de contournement normalement fermé placé entre un noeud d'entrée et un noeud de sortie du premier élément.

Selon un mode de réalisation, le circuit de comparaison est configuré pour comparer la tension aux bornes du deuxième élément au seuil.

Selon un mode de réalisation, le circuit de comparaison est configuré pour commander l'interrupteur de contournement en fonction de la tension aux bornes du deuxième élément.

Selon un mode de réalisation, le circuit de comparaison est configuré pour commander un interrupteur normalement ouvert relié à un noeud d'alimentation d'un circuit de commande du convertisseur d'énergie électrique.

Selon un mode de réalisation, le deuxième élément est configuré pour alimenter un circuit de commande du convertisseur d'énergie électrique, et un troisième élément de stockage d'énergie électrique est configuré pour alimenter une charge extérieure.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 représente de façon schématique un exemple d'un mode de réalisation d'un dispositif de conversion d'énergie électrique ;
la figure 2 représente un exemple d'un mode de réalisation d'un circuit de comparaison d'une tension à un seuil ;
la figure 3 est un chronogramme illustrant le fonctionnement du circuit de comparaison de la figure 2 ;
la figure 4 représente une variante de réalisation d'un circuit de comparaison d'une tension à un seuil ;
la figure 5 représente de façon schématique une variante de réalisation du dispositif de conversion d'énergie électrique de la figure 1 ; et
la figure 6 représente de façon schématique un exemple d'un autre mode de réalisation d'un dispositif de conversion d'énergie électrique.

Par souci de clarté, de mêmes éléments ont été désignés par de mêmes références aux différentes figures.

### Description détaillée

Des générateurs à récupération d'énergie ambiante (par exemple d'énergie mécanique) peuvent être utilisés dans des domaines variés, par exemple le transport, pour alimenter des capteurs de pression, de température, de vibration, etc., placés sur un véhicule ; l'industrie, pour alimenter des capteurs de surveillance de machines ; l'habitat, pour alimenter des interrupteurs sans fil, des capteurs de présence, des capteurs de contraintes, etc. ; le médical, pour alimenter des appareils d'assistance ou de surveillance implantés dans le corps d'un patient ; l'environnement, pour alimenter des capteurs de surveillance de phénomènes météorologiques ou autres ; la défense et le spatial, pour alimenter des capteurs de surveillance d'appareils ou de frontières ; et l'électronique grand public, pour alimenter totalement ou partiellement des appareils portatifs tels que des téléphones, lecteurs MP3, télécommande, etc. L'utilisation de générateurs à récupération d'énergie ambiante permet notamment de réaliser des capteurs sans fil totalement autonomes, donc faciles à mettre en place et ne nécessitant pas des opérations récurrentes et coûteuses de remplacement de batteries. L'utilisation de générateurs à récupération d'énergie ambiante permet aussi de prolonger la durée de vie des batteries de certains capteurs.

Dans un générateur à récupération d'énergie mécanique, l'énergie récupérée peut provenir de diverses sources, par exemple de vibrations, de chocs, de déformations, d'une force exercée par un utilisateur, etc. L'élément de conversion mécano-électrique peut être de type piézoélectrique, ou d'un autre type, par exemple de type électrostatique, électromagnétique, magnétostrictif, etc.

La plupart du temps, l'énergie électrique fournie par l'élément de conversion mécano-électrique n'est pas directement exploitable pour alimenter un système électronique. En effet, les systèmes électroniques usuels sont alimentés par des tensions continues de quelques volts, par exemple de l'ordre de 2 à 12 volts, alors que l'élément de conversion mécano-électrique fournit généralement une tension alternative ou transitoire de forte amplitude, par exemple supérieure à 30 volts, et un courant très faible, par exemple de l'ordre de 10 nano-ampères à 100 micro-ampères, ou moins.

Pour transformer l'énergie électrique fournie par l'élément de conversion mécano-électrique en énergie exploitable par un système électronique, un générateur à récupération d'énergie mécanique peut comprendre un dispositif de conversion d'énergie électrique, comprenant par exemple un convertisseur de tension ou de courant, ou un convertisseur courant/tension.

Le dispositif de conversion d'énergie électrique peut comprendre un élément de redressement, par exemple un pont de diodes, recevant l'énergie fournie par l'élément de conversion mécano-électrique, et, en sortie de l'élément de redressement, un élément capacitif de stockage, par exemple un condensateur, un accumulateur, ou une batterie, fournissant une tension continue de niveau adapté à l'alimentation d'un système électronique. Un problème est que le rendement d'un tel dispositif de conversion est relativement faible, notamment lorsqu'il existe une différence de niveau de tension importante entre l'entrée et la sortie de l'élément de redressement.

Pour augmenter le rendement de conversion, on peut prévoir un dispositif de conversion d'énergie électrique comportant un convertisseur d'énergie électrique actif, par exemple un convertisseur à découpage, l'élément de conversion mécano-électrique et l'élément de stockage. En fonctionnement, le convertisseur à découpage reçoit un signal (éventuellement redressé) d'amplitude dépendant de la quantité d'énergie mécanique reçue et des caractéristiques de l'élément de conversion mécano-électrique, et fournit, aux bornes de l'élément de stockage, un signal continu de niveau adapté à l'alimentation d'un système électronique. Les pertes liées à la différence de niveau de signal entre la sortie de l'élément de conversion mécano-électrique et l'élément de stockage sont ainsi réduites. Un problème est lié au fait qu'un convertisseur à découpage nécessite d'être alimenté pour pouvoir fonctionner. En régime établi, l'énergie électrique d'alimentation du convertisseur à découpage peut être prélevée dans l'élément de stockage de sortie du convertisseur de tension. Toutefois, pendant une phase de démarrage du générateur, si l'élément de stockage est déchargé, une alimentation d'appoint est nécessaire. Il peut de plus être nécessaire de prévoir un circuit de comparaison d'une tension à un seuil pour détecter la fin de la phase de démarrage. Un problème est que les circuits de comparaison de tension connus ont une consommation en énergie électrique relativement importante. En outre, à la fin de la phase de démarrage, la commutation entre l'alimentation d'appoint et l'alimentation par l'élément de stockage peut poser des difficultés.

Il serait souhaitable de pouvoir résoudre tout ou partie des problèmes des dispositifs de conversion d'énergie électrique connus.

En outre, il serait souhaitable de pouvoir disposer d'un circuit de comparaison d'une tension à un seuil palliant tout ou partie des problèmes des circuits de comparaison connus.

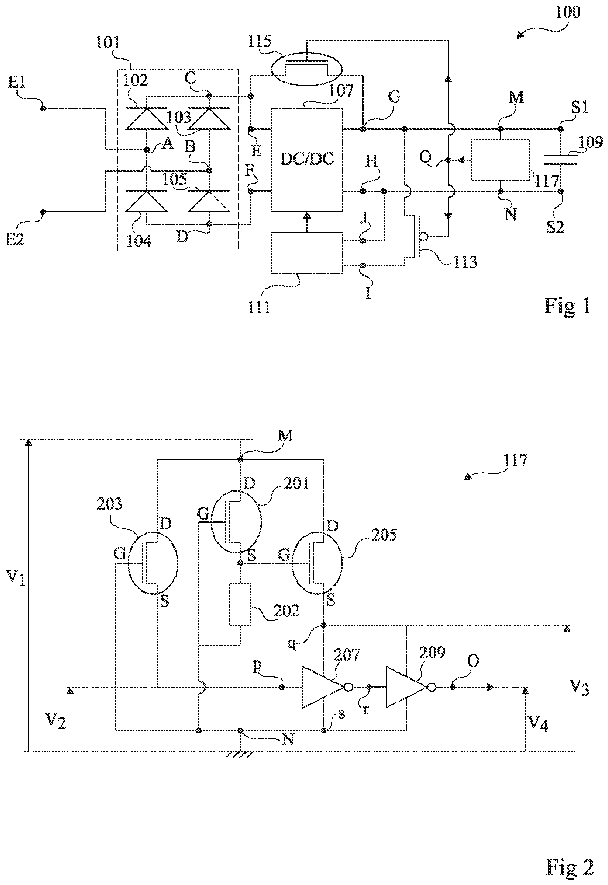

La figure 1 représente de façon schématique un exemple d'un mode de réalisation d'un dispositif de conversion d'énergie électrique 100, adapté à transformer une énergie électrique alternative ou transitoire, par exemple fournie par un élément de conversion mécano-électrique (non représenté) ou toute autre source d'énergie fluctuante ou intermittente, en une tension continue, par exemple compatible avec l'alimentation d'un système électronique (non représenté).

Le dispositif 100 comprend un élément de redressement 101 comportant des noeuds d'entrée A et B, respectivement reliés ou couplés à des noeuds d'entrée E1 et E2 du dispositif 100 (pouvant être reliés à des noeuds de sortie d'un dispositif de récupération d'énergie), et des noeuds de sortie C et D. Dans l'exemple représenté, l'élément de redressement 101 comprend une diode 102 entre les noeuds A et C, une diode 103 entre les noeuds B et C, une diode 104 entre les noeuds D et A, et une diode 105 entre les noeuds D et B, les anodes des diodes 102, 103, 104 et 105 étant respectivement côté noeud A, côté noeud B, côté noeud D, et côté noeud D. Le dispositif 100 comprend en outre un convertisseur à découpage 107 de type continu/continu (DC/DC), comportant des noeuds d'entrée E et F, respectivement reliés aux noeuds de sortie C et D de l'élément de redressement 101, et des noeuds de sortie G et H, respectivement reliés à des noeuds de sortie S1 et S2 du dispositif 100. Le dispositif 100 comprend de plus un élément de stockage 109, par exemple un condensateur, un accumulateur, ou une batterie électrique, entre les noeuds S1 et S2. L'élément 109 peut aussi avoir une fonction de filtrage. Le dispositif 100 comprend par ailleurs un circuit électronique 111 de contrôle de transistors (non visibles sur la figure 1) du convertisseur à découpage 107. Le circuit 111 comprend des noeuds d'alimentation haut I et bas J reliés respectivement aux noeuds S1 et S2. Dans l'exemple représenté, le noeud J est directement relié au noeud S2, et le noeud I est relié au noeud S1 par l'intermédiaire d'un interrupteur 113 normalement ouvert, par exemple un transistor MOS à canal P.

Selon un aspect, le dispositif 100 comprend un interrupteur 115 de contournement ("bypass switch" en anglais) normalement fermé ("normally on" en anglais), entre un noeud de sortie de l'élément de redressement 101 et un noeud de sortie du convertisseur à découpage 107. L'interrupteur 115 peut être un transistor normalement passant ("normally on" en anglais), ou transistor à appauvrissement, c'est-à-dire un transistor dans lequel un canal existe lorsqu'aucune tension n'est appliquée sur son noeud de commande (par exemple lorsque la tension grille-source est nulle dans le cas d'un transistor MOS). L'interrupteur 115 est par exemple un transistor DMOS, aussi appelé transistor MOS à déplétion ou à appauvrissement. Dans l'exemple de la figure 1, des noeuds de conduction de l'interrupteur 115 sont directement reliés respectivement au noeud C de sortie de l'élément de redressement 101 et au noeud G de sortie du convertisseur à découpage 107. A titre de variante, une diode (non représentée) peut être reliée en série de l'interrupteur 115, entre les noeuds C et G, par exemple en amont de l'interrupteur 115, de façon à n'autoriser le passage du courant dans l'interrupteur 115 que dans le sens du noeud C vers le noeud G.

Le dispositif 100 comprend de plus un circuit 117 de comparaison d'une tension à un seuil, adapté à commander les interrupteurs 115 et 113 en fonction de la tension aux bornes de l'élément de stockage 109. Dans l'exemple représenté, le circuit 117 comprend des noeuds d'entrée de potentiel haut M et de potentiel bas N reliés respectivement aux noeuds de sortie S1 et S2 du dispositif 100, et un noeud de sortie O relié aux grilles de commande des interrupteurs 115 et 113.

Le fonctionnement du dispositif de conversion d'énergie électrique de la figure 1 va maintenant être décrit.

Au début d'une phase de démarrage, par exemple lorsque le dispositif 100 n'a pas été utilisé pendant une longue période, l'élément de stockage 109 est déchargé, c'est-à-dire que la tension entre les noeuds de sortie S1 et S2 est sensiblement nulle. Le circuit 117 n'étant pas alimenté, aucun signal de commande n'est appliqué aux interrupteurs 115 et 113. L'interrupteur 115, qui est normalement fermé, est donc à l'état passant, et l'interrupteur 113, qui est normalement ouvert, est à l'état non passant. De plus, le circuit 111 de contrôle du convertisseur à découpage 107 n'étant pas alimenté, le convertisseur à découpage 107 est inactif.

Lorsqu'un signal électrique alternatif ou transitoire, par exemple fourni par un élément de conversion mécano-électrique d'un générateur à récupération d'énergie mécanique, est reçu sur les noeuds d'entrée E1 et E2 du dispositif 100, ce signal est redressé par l'élément 101, qui ne nécessite pas d'alimentation spécifique (autre que le signal d'entrée qu'il reçoit) pour fonctionner. L'interrupteur 115 étant à l'état passant, il forme un chemin conducteur de contournement du convertisseur à découpage 107, et le signal électrique redressé fourni en sortie de l'élément 101 est reporté sur les noeuds de sortie S1 et S2 du dispositif 100. Ce signal vient charger l'élément de stockage 109.

Lorsque le niveau de charge de l'élément de stockage 109 dépasse un seuil, le circuit 117 le détecte et commande l'ouverture de l'interrupteur 115 et la fermeture de l'interrupteur 113. Dans cet exemple, l'interrupteur 115 est un transistor à déplétion (DMOS) à canal N, et l'interrupteur 113 est un transistor à enrichissement (MOS) à canal P. L'application, par le circuit 117, d'un même signal de commande de niveau bas sur les grilles des transistors 115 et 113, permet donc de commander simultanément l'ouverture du transistor 115 et la fermeture du transistor 113.

La fermeture de l'interrupteur 113 provoque la mise sous tension du circuit 111 de contrôle du convertisseur à découpage 107, et donc l'activation du convertisseur 107. L'énergie électrique nécessaire à la commande des transistors du convertisseur à découpage 107 est puisée dans l'élément de stockage 109 par le circuit 111. L'ouverture de l'interrupteur 115 interrompt le chemin conducteur de contournement du convertisseur à découpage 107. Le signal électrique de sortie de l'élément de redressement 101 n'est donc plus directement reporté aux bornes de l'élément de stockage 109, mais est transformé par le convertisseur à découpage 107, et le signal de sortie du convertisseur 107 vient charger l'élément de stockage 109.

Un avantage du mode de réalisation de la figure 1 est que le dispositif 100 peut démarrer de façon autonome, même lorsque l'élément de stockage 109 est totalement déchargé (par exemple après une longue période sans utilisation). Le dispositif 100 ne nécessite donc pas d'alimentation d'appoint.

Un autre avantage est que, en régime établi, c'est-à-dire après une phase de démarrage au cours de laquelle l'élément de stockage 109 est chargé à un niveau suffisant pour alimenter le convertisseur à découpage 107, le dispositif 100 présente un rendement de conversion élevé par rapport à un dispositif ne comportant pas de convertisseur d'énergie électrique actif (c'est-à-dire recevant une énergie d'alimentation électrique spécifique, autre que le signal d'entrée à convertir).

A titre de variante, les interrupteurs 113 et 115 peuvent ne pas être commandés simultanément via un même signal, comme dans l'exemple de la figure 1, mais via des signaux distincts. A titre d'exemple, une unité de contrôle non représentée, par exemple un microcontrôleur, peut être prévue entre la sortie O du circuit 117 et les grilles de commande des interrupteurs 113 et 115 pour commander l'interrupteur 113 indépendamment du transistor 115. La fermeture de l'interrupteur 113 peut par exemple être commandée légèrement avant la fermeture de l'interrupteur 115 de façon à garantir que le convertisseur à découpage 107 soit opérationnel dès l'ouverture de l'interrupteur 115. Dans une autre variante de réalisation, l'interrupteur 113 peut être supprimé, c'est-à-dire que le noeud I peut être directement relié au noeud S1.

La figure 2 représente plus en détail un exemple d'un mode de réalisation du circuit 117 de détection de seuil de tension du dispositif de la figure 1, ou circuit de comparaison d'une tension à un seuil. Dans cet exemple, le circuit 117 comprend trois transistors MOS à déplétion (DMOS) 201, 203 et 205, et deux inverseurs CMOS (ou paires NMOS-PMOS) 207 et 209. Les drains (D) des transistors 201, 203 et 205 sont reliés au noeud d'entrée M de potentiel haut du circuit 117. La source (S) du transistor 201 est reliée au noeud d'entrée N de potentiel bas ou noeud de masse du circuit 117 par l'intermédiaire d'une résistance 202, la source (S) du transistor 203 est reliée à un noeud p d'entrée de l'inverseur 207, et la source (S) du transistor 205 est reliée à un noeud q d'alimentation haute des inverseurs 207 et 209. Les inverseurs 207 et 209 sont reliés en série, c'est-à-dire que la sortie r de l'inverseur 207 est reliée à l'entrée de l'inverseur 209. La sortie de l'inverseur 209 est reliée au noeud O de sortie du circuit 117. Le noeud N est relié à un noeud s d'alimentation basse des inverseurs 207 et 209. La grille du transistor 205 est reliée à la source du transistor 201. Les grilles des transistors 201 et 203 sont reliées au noeud N.

Le fonctionnement du circuit 117 de la figure 2 va maintenant être décrit en relation avec les figures 1, 2 et 3.

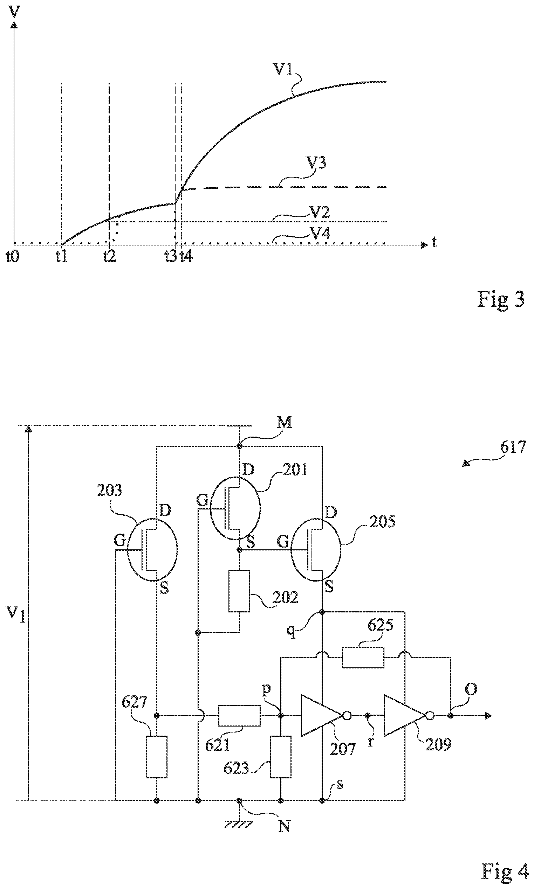

La figure 3 est un chronogramme illustrant l'évolution en fonction du temps, lors d'une phase de démarrage du dispositif 100 de la figure 1, des tensions V₁ entre les noeuds M et N du circuit 117, V₂ entre les noeuds p et N du circuit 117, V₃ entre les noeuds q et N du circuit 117, et V₄ entre les noeuds O et N du circuit 117.

Dans l'exemple de la figure 2, les transistors DMOS 201, 203 et 205 sont des transistors à canal N, c'est-à-dire des transistors normalement fermés, qui s'ouvrent lorsqu'une tension source-grille supérieure à un seuil positif de déclenchement ou d'ouverture est appliquée. On désignera ci-après par V_{TH201}, V_{TH203} et V_{TH205} les seuils d'ouverture respectifs des transistors 201, 203 et 205.

A un instant t0 de début d'une phase de démarrage, la tension V₁ entre les noeuds d'entrée M et N du circuit 117 est sensiblement nulle (élément de stockage 109 déchargé). Les tensions V₂, V₃, et V₄ sont aussi sensiblement nulles.

A un instant t1, lorsque l'élément de stockage 109 (figure 1) commence à se charger, la tension V₁ augmente. Les transistors 203 et 205 étant à l'état passant, les tensions V₂ et V₃ suivent la même progression que la tension V₁. La tension V₄ de sortie du circuit 117 augmente également.

A un instant t2, lorsque la tension V₂ approche du seuil d'ouverture V_{TH203} du transistor 203, le transistor 203 tend à s'ouvrir. Le transistor 203 se comporte alors comme un limiteur de tension, et la tension V₂ se stabilise sensiblement à la valeur V_{TH203}. La tension V₁ continue d'augmenter avec la charge du condensateur 109, et les tensions V₃ et V₄ suivent la même progression que la tension V₁.

A un instant t3, lorsque la tension V₃ d'alimentation des inverseurs 207 et 209 dépasse un seuil égal à environ deux fois le niveau de saturation V_{TH203} de la tension d'entrée V2 des inverseurs, la sortie r de l'inverseur 207 commute d'un état bas à un état haut. La sortie de l'inverseur 209 commute alors d'un état haut (tension V₄ sensiblement égale à la tension V₃ d'alimentation des inverseurs) à un état bas (tension V₄ sensiblement nulle), c'est-à-dire que le noeud O de sortie du circuit 117 est ramené sensiblement au potentiel du noeud de masse N. Cette commutation marque la fin de la phase de démarrage. Dans le dispositif conversion d'énergie électrique de la figure 1, elle provoque l'ouverture de l'interrupteur 115 et la fermeture de l'interrupteur 113, et donc l'activation du convertisseur à découpage 107.

A un instant t4 peu après l'instant t3, la tension V₃ se stabilise à une valeur sensiblement égale à V_{TH201} + V_{TH205}, et ce, même si la tension V₁ continue d'augmenter au-delà de cette valeur. Ceci permet de limiter la consommation des inverseurs 207 et 209.

Après l'instant t4, la tension de sortie V4 reste à l'état bas tant que la tension d'entrée V1 reste supérieure au seuil de commutation du circuit 117, c'est-à-dire approximativement deux fois le niveau de saturation V_{TH203} de la tension d'entrée V2 des inverseurs dans cet exemple. Si la tension V1 redescend en dessous de ce seuil, la tension de sortie V4 du circuit 117 commute à nouveau vers un état haut.

Un avantage du circuit 117 de la figure 2 est que, lorsque la tension V₁ atteint le seuil de commutation du circuit 117, le changement d'état de la sortie O du circuit 117 est particulièrement rapide. Lorsque le circuit 117 est utilisé dans le dispositif de conversion d'énergie électrique 100 de la figure 1, ceci permet notamment d'éviter un verrouillage indésirable du dispositif 100 dans une configuration dans laquelle les interrupteurs 113 et 115 seraient tous deux partiellement fermés.

Un autre avantage est que, après la phase de démarrage, lorsque le dispositif 100 fonctionne en régime établi, les inverseurs 207 et 209 ne commutent pas, et les transistors DMOS 201, 203 et 205 sont dans un état presque totalement ouvert, chaque transistor DMOS ayant sa tension source-grille sensiblement égale au seuil d'ouverture du transistor. Il en résulte que la consommation du circuit 117 en régime établi est très faible, par exemple inférieure à 50 nano-ampères.

Un autre avantage du circuit 117 est qu'il ne nécessite pas, pour fonctionner, de recevoir une alimentation électrique spécifique, autre que la tension à surveiller entre ses noeuds d'entrée M et N.

Les inverseurs 207 et 209 du circuit 117 sont par exemple des inverseurs dits simples, c'est-à-dire comportant chacun des premier et deuxième transistors complémentaires en série entre des noeuds d'alimentation haute et basse de l'inverseur, les grilles des deux transistors étant reliées entre elles. A titre de variante, les inverseurs 207 et 209 peuvent être des inverseurs dits encapsulés, c'est-à-dire comportant chacun, en plus des premier et deuxième transistors d'un inverseur simple, des troisième et quatrième transistors respectivement entre le noeud d'alimentation haute et la source du premier transistor, et entre le noeud d'alimentation basse et la source du deuxième transistor, les grilles des troisième et quatrième transistors étant reliées aux grilles des premier et deuxième transistors. A titre de variante, les inverseurs 207 et 209 peuvent être des inverseurs dits encapsulés retardés, c'est-à-dire comportant chacun, en plus des quatre transistors d'un inverseur encapsulé, un circuit de retard RC entre les grilles des premier et deuxième transistors, et les grilles des troisième et quatrième transistors. L'utilisation d'inverseurs de type encapsulé ou encapsulé-retardé permet notamment de limiter la consommation du circuit 117, en évitant qu'un chemin de conduction ne soit créé entre les noeuds d'alimentation haut et bas de l'inverseur lors de la commutation du circuit 117.

Les inventeurs ont constaté que le circuit 117 de la figure 2 présente de bonnes performances lorsqu'on utilise, pour le transistor DMOS 201, un composant référencé BF992 présentant un seuil d'ouverture de 1,4 volts, pour les transistors DMOS 203 et 205, des composants référencés BF994 présentant un seuil de d'ouverture de 1 volt, pour les inverseurs 207 et 209, des montages de type encapsulé utilisant des composants référencés MC14007, et pour la résistance 202, une résistance de 500 MΩ. Les modes de réalisation décrits ne se limitent bien entendu pas à ce cas particulier.

Diverses variantes du circuit 117 de la figure 2 peuvent être prévues, ces variantes pouvant, le cas échéant, être combinées.

A titre de première variante, une capacité peut être ajoutée entre le noeud de masse N du circuit 117, et chacune des entrées et/ou sorties des inverseurs 207 et 209, de façon à stabiliser les états d'entrée et/ou de sortie des inverseurs.

A titre de deuxième variante, une résistance peut être ajoutée entre le noeud de masse N du circuit 117, et chacune des entrées et/ou sorties des inverseurs 207 et 209, de façon à faciliter la commutation des inverseurs ou leur retour à l'état initial en cas de diminution de la tension V1.

Dans l'exemple de la figure 2, le transistor 203 joue le rôle d'un limiteur de la tension V₂ d'entrée de l'inverseur 207, et la cascade des transistors 201 et 205 joue le rôle d'un limiteur de la tension V₃ d'alimentation des inverseurs 207 et 209. A titre de troisième variante, on peut prévoir de réaliser chacun de ces limiteurs de tension avec un nombre de transistors DMOS cascadés différent de l'exemple de la figure 2, ce qui permet notamment d'ajuster le seuil de commutation du circuit 117. Par exemple, dans l'exemple de la figure 2, les transistors 201, 205 et la résistance 202 peuvent être remplacés par un unique transistor DMOS (dont le drain, la source et la grille sont respectivement connectés aux noeuds M, q et N) ayant un seuil d'ouverture égal à V_{TH201} + V_{TH205}, ou par un limiteur de tension comportant un nombre de transistors DMOS cascadés supérieur à 2, et le transistor 203 peut être remplacé par plusieurs transistors DMOS cascadés.

A titre de quatrième variante, le limiteur de la tension V3, formé dans l'exemple de la figure 2 par la cascade des transistors 201 et 205 et par la résistance 202, peut être remplacé par un limiteur de tension simplifié, comportant une première diode (non représentée) dont l'anode est connectée au noeud M et dont la cathode est connectée au noeud q. Dans cette quatrième variante, une deuxième diode (non représentée) peut en outre être prévue entre le noeud M et le drain (D) du transistor 203. On notera que chacune des première et deuxième diodes peut être remplacée par une association de plusieurs diodes en série, en fonction de la chute de tension que l'on souhaite obtenir entre le noeud M et le noeud q d'une part, et entre le noeud M et le drain du transistor 203 d'autre part.

On notera par ailleurs que le limiteur de la tension V3, formé dans l'exemple de la figure 2 par la cascade des transistors 201 et 205 et par la résistance 202, est facultatif. A titre de cinquième variante, ce limiteur de tension peut être supprimé, et le noeud M peut par exemple être directement connecté au noeud q.

A titre de sixième variante, les transistors DMOS 201, 203 et 205 du circuit 117 peuvent être remplacés par d'autres types d'interrupteurs normalement fermés ayant un fonctionnement similaire, c'est-à-dire tendant à s'ouvrir lorsqu'une tension de commande dépassant un seuil leur est appliquée, par exemple des transistors JFET.

A titre de septième variante, le circuit 117 peut comporter un nombre d'inverseurs CMOS en série supérieur à 2. Ceci permet notamment d'augmenter la vitesse de commutation du circuit. Alternativement, le circuit 117 peut comporter un unique inverseur (c'est-à-dire que l'inverseur 209 peut être supprimé, et la sortie r de l'inverseur 207 peut être directement reliée à la sortie O du circuit 117).

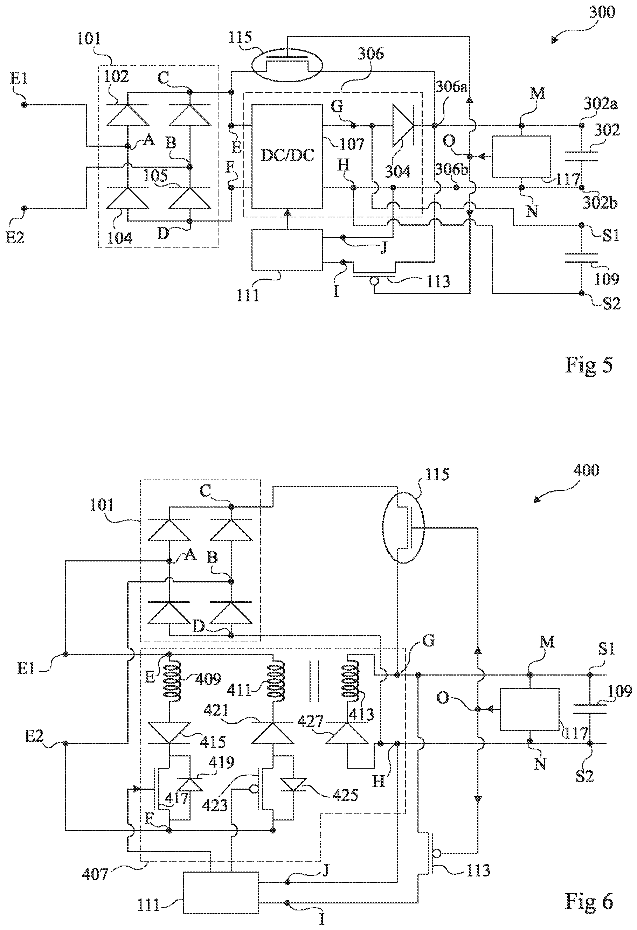

La figure 4 représente un autre exemple d'un mode de réalisation d'un circuit 617 de comparaison d'une tension à un seuil. A titre d'exemple, le circuit 617 peut être utilisé en remplacement du circuit 117 de comparaison d'une tension à un seuil dans le circuit de conversion d'énergie électrique décrit précédemment en relation avec la figure 1, ou dans des circuits de conversion d'énergie électrique du type décrit ci-après en relation avec les figures 5 et 6.

Dans l'exemple de la figure 4, le circuit 617 comprend les mêmes éléments que le circuit 117 de la figure 2, agencés sensiblement de la même manière, et comprend en outre des résistances supplémentaires. Dans la suite, seules les différences entre les circuits 617 et 117 seront détaillées. Dans l'exemple représenté, le circuit 617 comprend une résistance 621 entre le noeud p d'entrée de l'inverseur 207 et le noeud de source (S) du transistor 203 (au lieu d'une connexion directe dans le circuit 117 de la figure 2), une résistance 623 entre le noeud p et le noeud N, et une résistance 625 entre le noeud p d'entrée de l'inverseur 207 et le noeud O de sortie du circuit de comparaison. Une résistance 627 peut optionnellement être prévue entre le noeud de source (S) du transistor 203 et le noeud N. Les résistances 621, 623 et 625 confèrent au circuit 617 des propriétés d'hystérésis. Le circuit 617 se comporte comme un circuit de comparaison de type trigger de Schmitt à deux seuils de commutation, un seuil haut VH et un seuil bas VB (avec VB < VH). En d'autres termes, en fonctionnement, la sortie O du circuit 617 passe à l'état bas lorsque la tension V₁ entre les noeuds M et N dépasse le seuil VH, mais ne repasse à nouveau à l'état haut que lorsque la tension V₁ redescend en dessous du seuil VB.

Le circuit 617 trouve un intérêt tout particulier dans des circuits de conversion d'énergie électrique du type décrit précédemment en relation avec la figure 1, ou du type décrit ci-après en relation avec les figures 5 et 6. En effet, dans de tels circuits, la commutation du circuit de comparaison de tension provoque l'activation d'un convertisseur à découpage, et peut entraîner une diminution temporaire de la tension V₁ surveillée par le circuit de comparaison. En l'absence d'hystérésis, cette diminution de tension pourrait entraîner une nouvelle commutation du circuit de comparaison, provoquant la désactivation quasi-immédiate du convertisseur à découpage. Ce phénomène de diminution de tension surveillée à la commutation du circuit de comparaison s'observe tout particulièrement dans des circuits de conversion d'énergie électrique à deux éléments de stockage, du type décrit ci-après en relation avec la figure 5.

On notera que le circuit 617 de la figure 4 est compatible avec les diverses variantes de réalisation susmentionnées du circuit 117 de la figure 2. Dans un mode de réalisation préféré, on prévoit un circuit de comparaison de tension à un seuil du type représenté en figure 4, mais dans lequel le limiteur de tension formé par les transistors 201 et 205 et par la résistance 202 est remplacé par une première diode dont l'anode est connectée au noeud M et dont la cathode est connectée au noeud q, et dans lequel une deuxième diode est connectée en direct entre le noeud M et le drain (D) du transistor 203.

La figure 5 représente de façon schématique une variante de réalisation du dispositif de conversion d'énergie électrique de la figure 1. Le dispositif de conversion 300 de la figure 5 comprend les mêmes éléments que le dispositif 100 de la figure 1, et comprend en outre, en plus de l'élément de stockage 109 connecté entre les noeuds S1 et S2, un deuxième élément capacitif de stockage 302, par exemple un condensateur, dont une première électrode 302a est reliée au noeud G par l'intermédiaire d'une diode 304, l'anode de la diode 304 étant côté noeud G, et dont une deuxième électrode 302b est reliée au noeud H. Dans le dispositif 300, le convertisseur à découpage 107 et la diode 304 sont des composants d'un élément 306 dont des noeuds de sortie 306a et 306b sont reliés respectivement aux électrodes 302a et 302b de l'élément de stockage 302. Le dispositif 300 diffère en outre du dispositif 100 de la figure 1 en ce que les noeuds M et I d'alimentation haute des circuits 111 et 117 sont reliés non pas au noeud S1, comme dans l'exemple de la figure 1, mais au noeud de sortie 306a de l'élément 306, côté cathode de la diode 304 (par l'intermédiaire de l'interrupteur 113 pour le noeud I). De plus, l'interrupteur 115 relie le noeud C de sortie de l'élément de redressement 101 non pas directement au noeud G de sortie du convertisseur à découpage 107 comme dans le convertisseur 100, mais au noeud 306a.

Pendant une phase de démarrage, tant que le convertisseur à découpage 107 est inactif, seul l'élément de stockage 302 se charge. Lorsque l'élément 302 atteint un niveau de charge suffisant pour alimenter le convertisseur à découpage 107, le circuit 117 ouvre l'interrupteur 115 et ferme l'interrupteur 113, ce qui entraîne l'activation du convertisseur à découpage 107. En régime établi, les éléments de stockage 302 et 109 sont tous deux chargés par le signal électrique de sortie du convertisseur à découpage 107. En d'autres termes, la variante de réalisation de la figure 5 sépare l'élément de stockage utilisé pour l'alimentation du convertisseur à découpage 107 (élément 302) de celui utilisé pour l'alimentation d'un système électronique extérieur (élément 109). On peut par exemple prévoir un élément de stockage 109 de plus grande capacité que l'élément de stockage 302 (par exemple de l'ordre de 1 µF pour l'élément 302 et de l'ordre de 10 µF à 1 mF pour l'élément 109). Un avantage est que ceci permet de démarrer plus rapidement le convertisseur à découpage, la vitesse de charge de l'élément 302 étant supérieure à celle de l'élément 109.

A titre de variante, un nombre d'éléments de stockage supérieur à deux peut être prévu, par exemple pour fournir des tensions de niveaux différents pour alimenter simultanément plusieurs systèmes électroniques distincts.

On notera que pour réaliser un dispositif de conversion d'énergie électrique à deux éléments de stockage ou plus, d'autres montages que celui de la figure 5 peuvent être prévus. A titre d'exemple, le convertisseur à découpage peut comprendre un transformateur comportant, au primaire, un enroulement, et, au secondaire, autant d'enroulements qu'il y a d'éléments de stockage dans le dispositif de conversion, chaque enroulement du secondaire étant couplé électro-magnétiquement à l'enroulement primaire, et chaque enroulement étant relié à l'un des éléments de stockage du dispositif de conversion. Chaque élément de stockage est ainsi chargé principalement par l'énergie reçue par l'enroulement secondaire du transformateur qui lui est associé. A titre de variante, le convertisseur à découpage peut comprendre un transformateur comportant, au primaire, un enroulement, et au secondaire, un seul enroulement couplé électro-magnétiquement à l'enroulement primaire, l'énergie reçue par l'enroulement secondaire étant répartie entre les divers éléments de stockage, par exemple au moyen d'aiguillages utilisant des transistors MOS et/ou des diodes.

La figure 6 représente de façon schématique un exemple d'un autre mode de réalisation d'un dispositif de conversion d'énergie électrique 400, adapté à transformer un signal électrique alternatif ou transitoire (signal fluctuant), par exemple fourni par un élément de conversion mécano-électrique (non représenté), en un signal continu, par exemple compatible avec l'alimentation d'un système électronique (non représenté).

Le dispositif 400 comprend un élément de redressement 101, par exemple un pont de diodes, comportant des noeuds d'entrée A et B, respectivement reliés à des noeuds d'entrée E1 et E2 du dispositif, et des noeuds de sortie C et D. Le dispositif 400 comprend en outre un convertisseur à découpage 407 comportant des noeuds d'entrée E et F, respectivement reliés aux noeuds d'entrée E1 et E2 du dispositif 400, et des noeuds de sortie G et H, respectivement reliés à des noeuds de sortie S1 et S2 du dispositif 400. Le noeud de sortie D de l'élément de redressement 101 est directement relié au noeud de sortie H du convertisseur à découpage 407, et le noeud de sortie C de l'élément de redressement 101 est relié au noeud de sortie G du convertisseur à découpage 407 par l'intermédiaire d'un interrupteur normalement fermé 115. En d'autres termes, dans le mode de réalisation de la figure 6, le convertisseur à découpage est placé en parallèle de l'élément de redressement 101, entre l'entrée et la sortie du dispositif 400, plutôt qu'en série de l'élément de redressement comme dans les modes de réalisation des figures 1 et 3. Le dispositif 400 comprend de plus un élément de stockage 109, par exemple un condensateur, entre les noeuds S1 et S2. Le dispositif 400 comprend par ailleurs un circuit électronique 111 de contrôle de transistors du convertisseur à découpage 407. Le circuit 111 comprend des noeuds d'alimentation haut I et bas J reliés respectivement aux noeuds S1 et S2. Dans l'exemple représenté, le noeud J est directement relié au noeud S2, et le noeud I est relié au noeud S1 par l'intermédiaire d'un interrupteur 113 normalement ouvert. Le dispositif 400 comprend de plus un circuit 117 de comparaison d'une tension à un seuil, pour commander les interrupteurs 115 et 113 en fonction du niveau de charge de l'élément 109. Dans l'exemple représenté, le circuit 117 comprend des noeuds d'entrée de potentiel haut M et de potentiel bas N reliés respectivement aux noeuds S1 et S2, et un noeud de sortie O relié aux grilles de commande des interrupteurs 115 et 113.

Selon un aspect du mode de réalisation de la figure 6, le convertisseur à découpage 407 comprend lui-même un redresseur, de sorte que, en régime établi, lorsque le convertisseur à découpage est actif, l'élément de redressement 101 n'a plus besoin d'être utilisé, et peut être désactivé par l'ouverture de l'interrupteur 115.

Dans l'exemple de la figure 6, le convertisseur à découpage 407 comprend un transformateur comportant, au primaire, deux enroulements 409 et 411, et, au secondaire, un enroulement 413 couplé électro-magnétiquement à la fois à l'enroulement 409 et à l'enroulement 411. Côté primaire, le convertisseur à découpage 407 comporte une première branche comportant, en série entre les noeuds E et F, l'enroulement 409, une diode 415 dont l'anode est côté enroulement 409, et un transistor de découpage 417, par exemple un transistor MOS à canal N. La première branche comporte en outre, en antiparallèle du transistor 417 et en anti-série de la diode 415, une diode de roue libre 419 qui peut être la diode parasite source/drain du transistor 417. Le convertisseur à découpage 407 comporte en outre, côté primaire, une deuxième branche, parallèle à la première branche, comportant, en série entre les noeuds E et F, l'enroulement 411, une diode 421 dont la cathode est côté enroulement 411, et un transistor de découpage 423, par exemple un transistor MOS à canal P. La deuxième branche comporte en outre, en antiparallèle du transistor 423 et en anti-série avec la diode 421, une diode de roue libre 425 qui peut être la diode parasite source/drain du transistor 423. Côté secondaire, le convertisseur à découpage 407 comporte, en série entre les noeuds G et H, l'enroulement 413 et une diode 427 dont l'anode est côté noeud H.

Des modes de réalisation particuliers ont été décrits. Diverses variantes et modifications apparaîtront à l'homme de l'art.

En particulier, les modes de réalisation décrits dans la présente demande ne se limitent pas à l'exemple spécifique de circuit de démarrage décrit en relation avec la figure 2. L'homme du métier saura réaliser des dispositifs de conversion d'énergie électrique du type décrit dans la présente demande, en remplaçant le circuit 117 par un autre circuit de démarrage adapté à mettre en oeuvre le fonctionnement recherché, par exemple un circuit comportant un comparateur à référence interne dont une sortie est reliée aux grilles des interrupteurs 113 et 115, le comparateur étant configuré pour passer d'un état haut à un état bas lorsque la tension aux bornes d'un élément de stockage du dispositif dépasse un seuil.

De plus, les dispositifs de conversion d'énergie électrique décrits dans la présente demande peuvent être utilisés dans des systèmes autres que des générateurs à récupération d'énergie mécanique, par exemple des générateurs thermoélectriques, des générateurs photovoltaïques, des transpondeurs ou dispositifs radiofréquences, etc. Plus généralement, les dispositifs de conversion d'énergie électrique décrits peuvent être utilisés dans tout système nécessitant la transformation d'un signal électrique d'entrée en un signal électrique de niveau différent. Les dispositifs de conversion décrits trouvent un intérêt tout particulier lorsqu'il existe une différence de niveau de tension importante entre l'entrée et la sortie du dispositif, et/ou lorsque la source d'énergie électrique en entrée du dispositif est intermittente ou fluctuante.

On notera par ailleurs que l'élément de redressement prévu dans les dispositifs de conversion des figures 1, 4 et 5 est optionnel. De plus, la réalisation des convertisseurs à découpage 107 des dispositifs de conversion des figures 1 et 4 n'a pas été détaillée dans la présente demande. On notera que les modes de réalisation des figures 1 et 4 sont compatibles avec tous les convertisseurs à découpage usuels, et plus généralement, avec tous les convertisseurs d'énergie électrique actifs, c'est-à-dire comportant au moins un transistor, et nécessitant une alimentation électrique spécifique pour son fonctionnement. En outre, le mode de réalisation de la figure 6 ne se limite pas à l'exemple spécifique de convertisseur à découpage 407 décrit. Plus généralement, le mode de réalisation de la figure 6 est compatible avec tout convertisseur actif adapté à mettre en oeuvre une fonction de redressement.

Par ailleurs, les circuits 117 et 617 décrits en relation avec les figures 2 et 4 peuvent être utilisés dans d'autres dispositifs de conversion d'énergie électrique que ceux décrits dans la présente demande. A titre d'exemple, les circuits 117 et 617 peuvent être utilisés pour détecter un seuil de tension dans un dispositif de conversion d'énergie électrique du type décrit dans la demande de brevet 2873242 susmentionnée, ou dans l'article "Power Conversion and Integrated Circuit Architecture for High Voltage Piezoelectric Energy Harvesting" susmentionné.

De plus, bien que les circuits 117 et 617 soient particulièrement avantageux pour une utilisation dans des dispositifs de conversion d'énergie électrique provenant de sources fluctuantes ou intermittentes tels que des générateurs à récupération d'énergie ambiante, les circuits 117 et 617 peuvent aussi être utilisés dans d'autres dispositifs de conversion d'énergie électrique, et, plus généralement, dans tout dispositif nécessitant un circuit adapté à surveiller une tension et à faire commuter un noeud entre un premier et un deuxième état lorsque la tension à surveiller franchit un seuil.

## Revendications

1. Circuit (117 ; 617) de comparaison d'une tension (V₁) à un premier seuil, comportant :
un premier inverseur (207) comportant deux transistors complémentaires en série entre des premier (q) et second (s) noeuds d'alimentation, les grilles des deux transistors complémentaires étant reliées entre elles, et les premier (q) et second (s) noeuds d'alimentation du premier inverseur étant reliés respectivement à un premier noeud (M) d'application de ladite tension (V₁) par l'intermédiaire d'un limiteur de tension et à un second noeud (N) d'application de ladite tension (V₁) ; et
un premier interrupteur (203) normalement fermé reliant une entrée (p) du premier inverseur (207) au premier noeud (M) d'application de ladite tension (V₁), une grille de commande (G) du premier interrupteur (203) étant reliée au deuxième noeud (N) d'application de ladite tension (V₁),
le circuit étant configuré de façon que le premier seuil dépend d'un deuxième seuil d'ouverture du premier interrupteur normalement fermé.

2. Circuit (117 ; 617) selon la revendication 1, dans lequel ledit limiteur de tension comprend un deuxième interrupteur (205) normalement fermé entre le premier noeud (M) d'application de ladite tension (V1) et le premier noeud (q) d'alimentation du premier inverseur.

3. Circuit (117 ; 617) selon la revendication 2, dans lequel ledit limiteur de tension comprend en outre au moins un troisième interrupteur (201) normalement fermé cascadé avec le deuxième interrupteur (205).

4. Circuit (117 ; 617) selon la revendication 1, dans lequel ledit limiteur de tension comprend une diode dont l'anode est côté premier noeud (M) d'application de ladite tension (V₁) et dont la cathode est côté premier noeud (q) d'alimentation du premier inverseur (207).

5. Circuit (117 ; 617) selon l'une quelconque des revendications 1 à 4, comportant un deuxième inverseur (209) en série avec le premier inverseur (207).

6. Circuit (117 ; 617) selon la revendication 5, dans lequel un noeud de sortie (O) du circuit est relié à une sortie du deuxième inverseur (209).

7. Circuit (117 ; 617) selon l'une quelconque des revendications 1 à 6, dans lequel le premier interrupteur (203) est un transistor MOS à déplétion.

8. Circuit (617) selon l'une quelconque des revendications 1 à 7, dans lequel l'entrée (p) du premier inverseur (207) est reliée à une sortie (O) du circuit par l'intermédiaire d'une première résistance (625).

9. Circuit (617) selon l'une quelconque des revendications 1 à 8, dans lequel l'entrée (p) du premier inverseur (207) est reliée au deuxième noeud (N) d'application de ladite tension (V₁) par l'intermédiaire d'une deuxième résistance (623).

10. Circuit (617) selon l'une quelconque des revendications 1 à 9, dans lequel l'entrée (p) du premier inverseur (207) est reliée au premier interrupteur (203) par l'intermédiaire d'une troisième résistance (621).

11. Circuit (100 ; 300 ; 400) de conversion d'énergie comportant :
un premier élément (107 ; 306 ; 407) comprenant un convertisseur d'énergie électrique (107 ; 307 ; 407) ; et
un circuit (117 ; 617) de comparaison de tension selon l'une quelconque des revendications 1 à 10.

12. Circuit (100 ; 300 ; 400) selon la revendication 11, comportant en outre un deuxième élément (109 ; 302) de stockage d'énergie électrique, susceptible d'être alimenté par ledit premier élément (107 ; 306 ; 407).

13. Circuit (100 ; 300 ; 400) selon la revendication 12, comportant en outre un interrupteur de contournement (115) normalement fermé placé entre un noeud (E) d'entrée et un noeud (G ; 306a) de sortie du premier élément (107 ; 306 ; 407).

14. Circuit (100 ; 300 ; 400) selon la revendication 12 ou 13, dans lequel le circuit (117 ; 617) de comparaison est configuré pour comparer la tension aux bornes du deuxième élément (109 ; 302) audit seuil.

15. Circuit (100 ; 300 ; 400) selon la revendication 14 dans son rattachement à la revendication 13, dans lequel le circuit (117 ; 617) de comparaison est configuré pour commander ledit interrupteur (115) de contournement en fonction de la tension aux bornes du deuxième élément (109 ; 302).

16. Circuit (100 ; 300 ; 400) selon l'une quelconque des revendications 11 à 15, dans lequel le circuit (117 ; 617) de comparaison est configuré pour commander un interrupteur (113) normalement ouvert relié à un noeud d'alimentation d'un circuit (111) de commande dudit convertisseur d'énergie électrique (107 ; 307 ; 407).

17. Circuit (300) selon la revendication 13, dans lequel le deuxième élément (302) est configuré pour alimenter un circuit (111) de commande dudit convertisseur d'énergie électrique (107 ; 307 ; 407), et dans lequel un troisième élément (109) de stockage d'énergie électrique est configuré pour alimenter une charge extérieure.

## Patentansprüche

1. Eine Schaltung (117; 617) zum Vergleichen einer Spannung (V₁) mit einem ersten Schwellenwert, die Folgendes aufweist:
einen ersten Inverter (207), der zwei komplementäre Transistoren in Reihe zwischen ersten (q) und zweiten (s) Stromversorgungsknoten aufweist, und die Gatter der zwei komplementären Transistoren aneinander gekoppelt sind und die ersten (q) und zweiten (s) Stromversorgungsknoten des ersten Inverters jeweils an einen ersten Knoten (M) der Anlegens der Spannung (V₁) über einen Spannungsbegrenzer und an einen zweiten Knoten (N) des Anlegens der Spannung (V₁) gekoppelt sind; und
einen ersten Normalerweise-An-Schalter (203), der einen Eingang (p) des ersten Inverters (207) an den ersten Knoten (M) des Anlegens der Spannung (V₁) koppelt, und ein Steuergatter (G) des ersten Schalters (203), der mit dem zweiten Knoten (N) des Anlegens der Spannung (V₁) verbunden ist,
wobei die Schaltung so konfiguriert ist, dass der erste Schwellenwert von einem zweiten Abschalt-Schwellenwert des ersten Normalerweise-An-Schalters abhängt.

2. Schaltung (117; 617) nach Anspruch 1, wobei der Spannungsbegrenzer einen zweiten Normalerweise-An-Schalter (205) zwischen dem ersten Knoten (M) des Anlegens der Spannung (V₁) und dem ersten Stromversorgungsknoten (q) des ersten Inverters aufweist.

3. Schaltung (117; 617) nach Anspruch 2, wobei der Spannungsbegrenzer ferner wenigstens einen dritten Normalerweise-An-Schalter (201) aufweist, der mit dem zweiten Schalter (205) hintereinandergeschaltet ist.

4. Schaltung (117; 617) nach Anspruch 1, wobei der Spannungsbegrenzer eine Diode aufweist, dessen Anode an der Seite des ersten Knoten (M) des Anlegens der Spannung (V₁) und dessen Kathode an der Seite des ersten Stromversorgungsknoten (q) des ersten Inverters (207) ist.

5. Schaltung (117; 617) nach einem der Ansprüche 1 bis 4, die einen zweiten Inverter (209) in Reihe mit dem ersten Inverter (207) aufweist.

6. Schaltung (117; 617) nach Anspruch 5, wobei ein Ausgangsknoten (O) der Schaltung mit einem Ausgang des zweiten Inverters (209) verbunden ist.

7. Schaltung (117; 617) nach einem der Ansprüche 1 bis 6, wobei der erste Schalter (203) einen Depletion-MOS-Transistor aufweist.

8. Schaltung (617) nach einem der Ansprüche 1 bis 7, wobei der Eingang (p) des ersten Inverters (207) mit einem Ausgang (O) der Schaltung über einen ersten Widerstand (625) verbunden ist.

9. Schaltung (617) nach einem der Ansprüche 1 bis 8, wobei der Eingang (p) des ersten Inverters (207) mit dem zweiten Knoten (N) des Anlegens der Spannung (V₁) über einen zweiten Widerstand (623) verbunden ist.

10. Schaltung (617) nach einem der Ansprüche 1 bis 9, wobei der Eingang (p) des ersten Inverters (207) mit dem ersten Schalter (203) über einen dritten Widerstand (621) verbunden ist.

11. Eine Energiewandlerschaltung (100; 300; 400), die Folgendes aufweist:
ein erstes Element (107; 306; 407), das einen elektrischen Energiewandler (107; 307; 407) aufweist; und
die Spannungsvergleichsschaltung (117; 617) nach einem der Ansprüche 1 bis 10.

12. Schaltung (100; 300; 400) nach Anspruch 11, die ferner ein zweites elektrisches Energiespeicherelement (109; 302) aufweist, das in der Lage ist von dem ersten Element (107; 306; 407) versorgt zu werden.

13. Schaltung (100; 300; 400) nach Anspruch 12, die ferner einen Normalerweise-An-Bypassschalter (115) aufweist, der zwischen einem Eingangsknoten (E) und einem Ausgangsknoten (G; 306a) des ersten Elements (107; 306; 407) angeordnet ist.

14. Schaltung (100; 300; 400) nach Anspruch 12 oder 13, wobei die Vergleichsschaltung (117; 617) konfiguriert ist zum Vergleichen der Spannung über dem zweite Element (109; 302) mit dem Schwellenwert.

15. Schaltung (100; 300; 400) nach Anspruch 14 und Anspruch 13, wobei die Vergleichsschaltung (117; 617) konfiguriert ist zum Steuern des Bypassschalters (115) gemäß der Spannung über dem zweiten Element (109; 302).

16. Schaltung (100; 300; 400) nach einem der Ansprüche 11 bis 15, wobei die Vergleichsschaltung (117; 617) konfiguriert ist zum Steuern eines Normalerweise-Aus-Schalters (113), der mit einem Stromversorgungsknoten einer Schaltung (111) zum Steuern des elektrischen Energiewandlers (107; 307; 407) verbunden ist.

17. Schaltung (300) nach Anspruch 13, wobei das zweite Element (302) konfiguriert ist zum Versorgen einer Schaltung (111) zum Steuern des elektrischen Energiewandlers (107; 307; 407) und wobei ein drittes elektrisches Energiespeicherelement (109) konfiguriert ist zum Versorgen einer externen Last.

## Claims

1. A circuit (117; 617) for comparing a voltage (V₁) with a first threshold, comprising:
a first inverter (207) comprising two complementary transistors in series between first (q) and second (s) power supply nodes, the gates of the two complementary transistors being coupled to each other, and the first (q) and second (s) power supply nodes of the first inverter being coupled respectively to a first node (M) of application of said voltage (V₁) via a voltage limiter and to a second node (N) of application of said voltage (V₁); and
a first normally-on switch (203) coupling an input (p) of the first inverter (207) to the first node (M) of application of said voltage (V₁), a control gate (G) of the first switch (203) being connected to the second node (N) of application of said voltage (V₁),
the circuit being configured such that the first threshold depends on a second turn-off threshold of the first normally-on switch.

2. The circuit (117; 617) of claim 1, wherein said voltage limiter comprises a second normally-on switch (205) between the first node (M) of application of said voltage (V₁) and the first power supply node (q) of the first inverter.

3. The circuit (117; 617) of claim 2, wherein said voltage limiter further comprises at least one third normally-on switch (201) cascaded with the second switch (205).

4. The circuit (117; 617) of claim 1, wherein said voltage limiter comprises a diode having its anode on the side of the first node (M) of application of said voltage (V₁) and having its cathode on the side of the first power supply node (q) of the first inverter (207).

5. The circuit (117; 617) of any of claims 1 to 4, comprising a second inverter (209) in series with the first inverter (207).

6. The circuit (117; 617) of claim 5, wherein an output node (O) of the circuit is connected to an output of the second inverter (209).

7. The circuit (117; 617) of any of claims 1 to 6, wherein the first switch (203) comprises a depletion MOS transistor.

8. The circuit (617) of any of claims 1 to 7, wherein the input (p) of the first inverter (207) is connected to an output (O) of the circuit via a first resistor (625).

9. The circuit (617) of any of claims 1 to 8, wherein the input (p) of the first inverter (207) is connected to the second node (N) of application of said voltage (V₁) via a second resistor (623).

10. The circuit (617) of any of claims 1 to 9, wherein the input (p) of the first inverter (207) is connected to the first switch (203) via a third resistor (621).

11. An energy conversion circuit (100; 300; 400) comprising:
a first element (107; 306; 407) comprising an electrical energy converter (107; 307; 407); and
the voltage comparison circuit (117; 617) of any of claims 1 to 10.

12. The circuit (100; 300; 400) of claim 11, further comprising a second electrical energy storage element (109; 302), capable of being powered by said first element (107; 306; 407).

13. The circuit (100; 300; 400) of claim 12, further comprising a normally-on bypass switch (115) placed between an input node (E) and an output node (G; 306a) of the first element (107; 306; 407).

14. The circuit (100; 300; 400) of claim 12 or 13, wherein the comparison circuit (117; 617) is configured to compare the voltage across the second element (109; 302) with said threshold.

15. The circuit (100; 300; 400) of claim 14 and claim 13, wherein the comparison circuit (117; 617) is configured to control said bypass switch (115) according to the voltage across the second element (109; 302).

16. The circuit (100; 300; 400) of any of claims 11 to 15, wherein the comparison circuit (117; 617) is configured to control a normally-off switch (113) connected to a power supply node of a circuit (111) for controlling said electrical energy converter (107; 307; 407).

17. The circuit (300) of claim 13, wherein the second element (302) is configured to power a circuit (111) for controlling said electrical energy converter (107; 307; 407), and wherein a third electrical energy storage element (109) is configured to power an external load.
